(19)

Europäisches
Patentamt

European
Patent Office

Office européen
des brevets

(11) **EP 2 988 422 A1**

(12) **EUROPEAN PATENT APPLICATION**

(43) Date of publication:
**24.02.2016 Bulletin 2016/08**

(21) Application number: **15181503.2**

(22) Date of filing: **19.08.2015**

(51) Int Cl.:
**H03M 1/52** (2006.01)　　**H03M 1/18** (2006.01)
**B60R 16/023** (2006.01)

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **22.08.2014　JP 2014169535**

(71) Applicant: **Renesas Electronics Corporation
Tokyo 135-0061 (JP)**

(72) Inventor: **GOTO, Masashi
Kodaira-shi, Tokyo 187-8588 (JP)**

(74) Representative: **Glawe, Delfs, Moll
Partnerschaft mbB von
Patent- und Rechtsanwälten
Postfach 26 01 62
80058 München (DE)**

(54) **SEMICONDUCTOR DEVICE, ANALOG-TO-DIGITAL CONVERSION METHOD, ONBOARD SYSTEM, AND MEASUREMENT METHOD**

(57)    There is provided a semiconductor device including: an integrator that repeats integrating a first reference voltage after integrating an analog signal; a comparator that compares an output of the integrator and a second reference voltage; a counter circuit that counts a first integration time determined to integrate the analog signal, and a second integration time until the output of the integrator reaches the second reference voltage from start of integration of the first reference voltage; a calculation circuit that calculates a digital value of the analog signal based on the first and the second integration times; a control circuit that performs control so that the analog signal is input to the integrator while the counter circuit counts the first integration time; and an integration time update circuit that updates the first integration time counted by the counter circuit based on the second integration time counted thereby.

Fig. 1

**Description**

CROSS-REFERENCE TO RELATED APPLICATIONS

This application is based upon and claims the benefit of priority from Japanese patent application No. 2014-169535, filed on August 22, 2014, the disclosure of which is incorporated herein in its entirety by reference.

BACKGROUND

The present invention relates to a semiconductor device, an analog-to-digital conversion method, an onboard system, and a measurement method and, for example, to a technology of integrating an analog signal to obtain a digital value.

There is a double integration type A/D conversion as analog-to-digital conversion in which an analog signal is converted into a digital value. Generally, although a double integration type A/D converter is an A/D converter that has higher accuracy and is more resistant to noise compared with other types of converters, it has a feature suitable for measurement of a signal that relatively slowly changes since it requires time for A/D conversion. Therefore, for example, in an onboard system, such as an engine control system needing high accuracy and noise resistance, double integration type A/D conversion is performed. In such an onboard system, since a vehicle is controlled based on measurement values, such as intake and exhaust temperatures of an engine, accuracy of the measurement values affects accuracy of the control. For this reason, highly accurate A/D conversion is required in the onboard system.

The double integration type A/D converter is, for example, disclosed in Japanese Unexamined Patent Application Publication No. 1993-83135 and Japanese Unexamined Patent Application Publication No. 1991-23719.

SUMMARY

An object of the present invention is to improve accuracy of analog-to-digital conversion.

The other problems and new features will be apparent from description of the present specification and accompanying drawings.

According to one embodiment, a semiconductor device counts a first integration time determined to integrate an analog signal, and a second integration time until an output of an integrator reaches a second reference voltage from start of integration of a first reference voltage, and updates the first integration time based on the counted second integration time.

According to the above-described one embodiment, accuracy of analog-to-digital conversion can be improved.

BRIEF DESCRIPTION OF THE DRAWINGS

The above and other aspects, advantages and features will be more apparent from the following description of certain embodiments taken in conjunction with the accompanying drawings, in which:

Fig. 1 is a circuit diagram showing a configuration of a semiconductor device in accordance with an embodiment 1;
Fig. 2 is a time chart showing operation of the semiconductor device in accordance with the embodiment 1;
Fig. 3 is a graph showing differences in integration times for each potential of an analog signal in the semiconductor device in accordance with the embodiment 1;
Fig. 4A is a graph showing conversion errors of an A/D converter, and shows the conversion errors of a semiconductor device in accordance with a comparative example;
Fig. 4B is a graph showing conversion errors of an A/D converter, and shows the conversion errors of the semiconductor device in accordance with the embodiment 1;
Fig. 5 is a schematic diagram showing a configuration of a vehicle in which an onboard system in accordance with an embodiment 2 has been mounted;
Fig. 6 is a block diagram showing a summary of a configuration of the onboard system in accordance with the embodiment 2;
Fig. 7 is a block diagram showing a detailed configuration of the onboard system in accordance with the embodiment 2;
Fig. 8 is a circuit diagram showing a configuration of a semiconductor device in accordance with an embodiment 3;
Fig. 9 is a time chart showing operation at the time of the Nth conversion of the semiconductor device in accordance with the embodiment 3;
Fig. 10 is a graph showing differences in integration times for each potential of an analog signal in the semiconductor device in accordance with the embodiment 3;
Fig. 11 is a block diagram showing a detailed configuration of an onboard system in accordance with an embodiment 4;

Fig. 12 is a time chart showing A/D conversion performed by a sensor I/F unit in accordance with the embodiment 4;

Fig. 13 is a circuit diagram showing a configuration of the semiconductor device in accordance with the comparative example;

Fig. 14 is a graph showing time transition of an integration output of an integrator in the semiconductor device in accordance with the comparative example; and

Fig. 15 is a graph showing a relation between magnitude of an analog signal and a time required for conversion.

DETAILED DESCRIPTION

<Examination in advance>

Before explaining embodiments, contents of an examination conducted in advance by the present inventor will be explained.

<Explanation of a configuration of a comparative example>

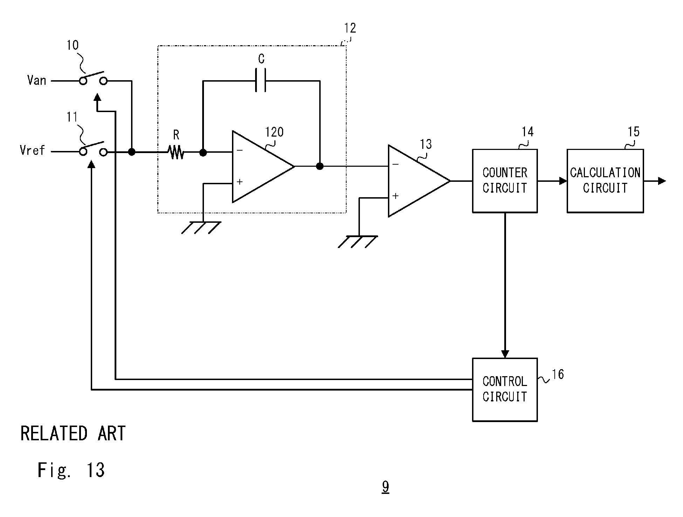

Fig. 13 is a circuit diagram showing a configuration of a semiconductor device 9 in accordance with a comparative example. The semiconductor device 9 is a double integration type A/D converter that has: switches 10 and 11; an integrator 12; a comparator 13; a counter circuit 14; a calculation circuit 15; and a control circuit 16.

The switches 10 and 11 switch an input to the integrator 12. Specifically, the switch 10 switches whether to input an analog signal Van to the integrator 12, and the switch 11 switches whether to input an integrated reference voltage Vref (a first reference voltage), which is a predetermined voltage, to the integrator 12. The switches 10 and 11 operate in accordance with control by the control circuit 16.

The integrator 12 is configured to include: a resistor R; a capacitor C; and an operational amplifier 120. The integrator 12 is a circuit that integrates the input switched by the switches 10 and 11. The integrator 12 outputs an integration output Vo to the comparator 13. The integrator 12 repeats integrating the integrated reference voltage Vref after integrating the analog signal in accordance with the control of the switches 10 and 11 by the control circuit 16 that will be mentioned later.

The comparator 13 compares the integration output Vo of the integrator 12 with a comparison reference voltage (a second reference voltage), and detects whether or not the integration output Vo is the comparison reference voltage (0 V). When the integration output Vo of the integrator 12 is the comparison reference voltage, the comparator 13 outputs a detection signal to the counter circuit 14.

The counter circuit 14 counts a time T1 (a first integration time) determined in order for the integrator 12 to integrate the analog signal, and outputs a signal to the control circuit 16. In addition, the counter circuit 14 counts a time T2 (a second integration time) until the comparator 13 detects that the integration output Vo of the integrator 12 has reached the comparison reference voltage from start of integration of the integrated reference voltage Vref by the integrator 12, and outputs a signal to the control circuit 16 and the calculation circuit 15. Hereinafter, the above-described first integration time is referred to as the time T1, and the above-described second integration time is referred to as the time T2.

The control circuit 16 controls the switches 10 and 11 based on an output of the counter circuit 14. Specifically, the control circuit 16 first controls the switch 10 so that the analog signal Van side becomes ON, and subsequently, keeps the switch 10 ON until the counter circuit 14 clocks the time T1. As described above, the control circuit 16 controls the switches 10 and 11 so that the analog signal Van is input to the integrator 12, while the counter circuit 14 counts the time T1. When the time T1 is counted by the counter circuit 14, the control circuit 16 controls the switch 10 so that the analog signal Van side becomes OFF, and controls the switch 11 so that the integrated reference voltage Vref side becomes ON. Further, when the counter circuit 14 clocks the time T2, the control circuit 16 controls the switch 11 to be turned off.

The calculation circuit 15 is the circuit that calculates a digital value of the analog signal based on the time T1 and the time T2 clocked by the counter circuit 14. Contents of the calculation by the calculation circuit 15 will be mentioned later.

The semiconductor device 9 first integrates the analog signal Van sampled during the time T1 by the time T1 according to the above-described configuration, and next, integrates the predetermined integrated reference voltage Vref by the time T2. In a manner as described above, the semiconductor device 9 quantizes the analog signal Van by two-times integration, and outputs a potential of the analog signal Van as an A/D conversion result.

<Explanation of operation of comparative example>

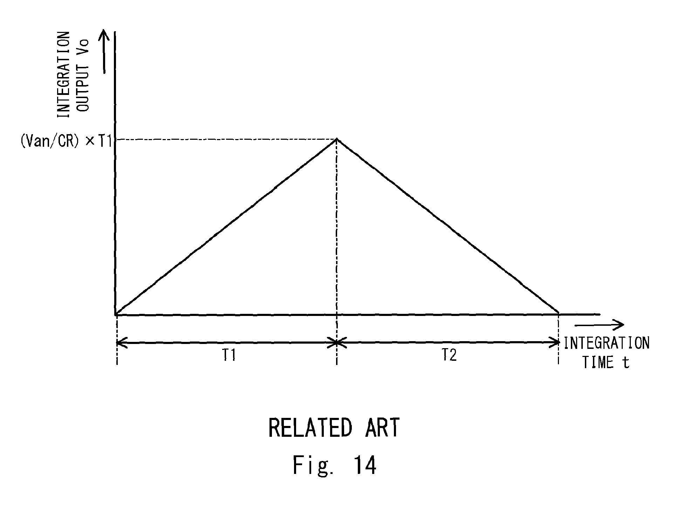

Here, operation of the semiconductor device 9 will be explained. Fig. 14 is a graph showing time transition of the integration output Vo of the integrator 12 in the semiconductor device 9 in accordance with the comparative example. When the analog signal Van is input to the integrator 12, the integration output Vo by the integrator 12 increases along with an integration time t as shown in the following Formula (1). Note that a reference character CR denotes a time constant.

$$\mathrm{Vo} = (\mathrm{Van/CR})\mathrm{t} \ \ldots \ (1)$$

Accordingly, the integration output Vo at the time of the elapse of the time T1 is expressed by the following Formula (2).

$$\mathrm{Vo} = (\mathrm{Van/CR}) \times \mathrm{T1} \ \ldots \ (2)$$

When the time T1 elapses, the control circuit 16 turns off the switch 10, and turns on the switch 11. As a result of this, the integrated reference voltage Vref is input to the integrator 12. When integration of the integrated reference voltage Vref is started by the integrator 12, the integration output Vo decreases in proportion to the integration time t. At this time, a slope of change of the integration output Vo is determined by the integrated reference voltage Vref and the time constant CR regardless of a magnitude of the input analog signal Van. Specifically, the slope of the change of the integration output Vo is Vref/CR. Additionally, when the integration output Vo of the integrator 12 becomes the comparison reference voltage (0 V), the comparator 13 outputs a detection signal to the counter circuit 14.

The counter circuit 14 outputs to the calculation circuit 15 the time T2 counted until the integration output Vo reaches the comparison reference voltage (0 V) after the switch of the integrated reference voltage Vref side becomes ON, based on the detection signal of the comparator 13.

Here, the integration output Vo at the time of the elapse of the time T2 satisfies a relation shown by the following Formula (3).

$$\mathrm{Vo} = (\mathrm{Van/CR}) \times \mathrm{T1} + (\mathrm{Vref/CR}) \times \mathrm{T2} = 0 \ \ldots \ (3)$$

Accordingly, the calculation circuit 15 outputs the A/D conversion result of the analog signal Van by a calculation shown by the following Formula (4).

$$\mathrm{Van} = -\mathrm{Vref} \times (\mathrm{T2/T1}) \ \ldots \ (4)$$

In addition, when Formula (4) is transformed, the following Formula (5) is obtained.

$$\mathrm{T2} = (\mathrm{Van/(-Vref)}) \times \mathrm{T1} \ \ldots \ (5)$$

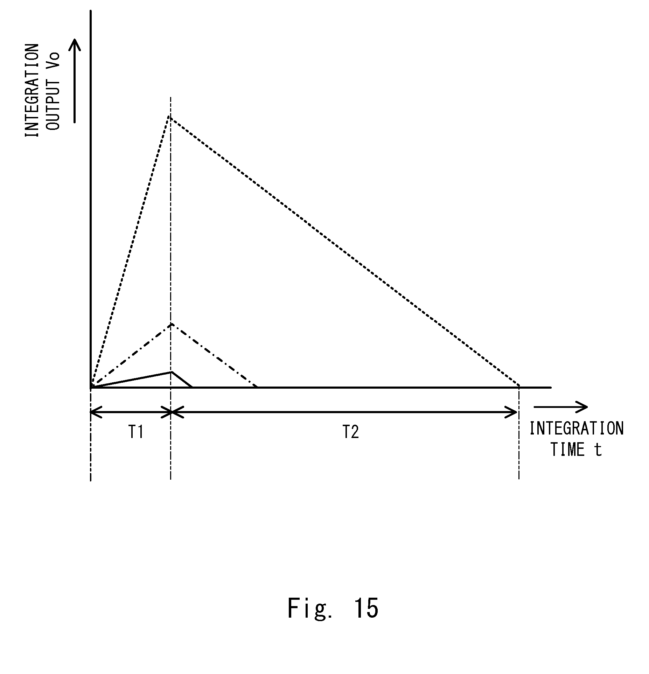

Here, since the integrated reference voltage Vref and the time T1 are constants, it turns out that the time T2 depends on the Van. Namely, while the time T1 is constant regardless of the potential of the analog signal Van, the time T2 differs depending on the potential of the analog signal Van. Specifically, as shown in Fig. 15, the higher the potential of the analog signal Van is, the longer a time (T1 + T2) required for conversion becomes, while the lower the potential of the analog signal Van is, the shorter the time (T1 + T2) required for conversion becomes. Note that in Fig. 15, a horizontal axis denotes the integration time t and that a vertical axis denotes the integration output Vo. In addition, a dashed line denotes an integration output when the analog signal Van of a maximum potential is input to the integrator 12, a continuous line denotes an integration output when the analog signal Van of a minimum potential is input to the integrator 12, and an alternate long and short dash line denotes an integration output when the analog signal Van of a potential between the maximum potential and the minimum potential is input to the integrator 12.

Since the times T1 and T2 are sampled by the counter circuit 14, resolution of the times T1 and T2 depends on a frequency of a clock that operates the counter circuit 14. For this reason, the resolution of the times T1 and T2 is represented as the number of clocks. Accordingly, since the resolution of the times T1 and T2 can be increased by increasing the number of clocks to sample the times T1 and T2 in the semiconductor device 9, it becomes possible to calculate the analog signal Van with high accuracy from a calculation result of the above-described Formula (4).

<Explanation of contents of examination>

The present inventor examined the next two methods as methods for increasing the number of clocks to sample the times T1 and T2. The first method is a method for increasing the resolution of the times T1 and T2 by increasing the frequency of the clock to sample the times T1 and T2. However, in this case, there is a problem that power consumption increases in association with increasing the clock frequency. The second method is a method for increasing the number of clocks to sample the times T1 and T2 by lengthening the times T1 and T2. However, in the case of this method, since it cannot be guaranteed to end conversion within a predetermined period, for example, with respect to an A/D converter in which ending integration for one conversion within the predetermined period has been standardized as product specifications etc., there is a problem that the times T1 and T2 cannot be simply lengthened.

Hereinafter, embodiments will be explained with reference to drawings. Note that since the drawings are simplified, technical scopes of the embodiments must not be construed narrowly on the basis of description of these drawings. In addition, the same symbol is attached to the same element, and overlapping description will be omitted.

<Embodiment 1>

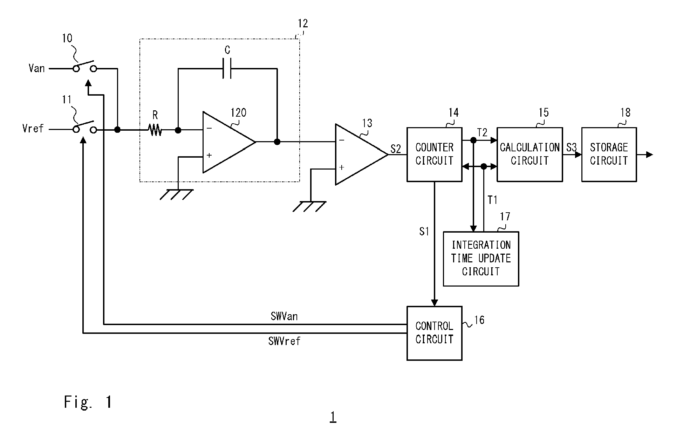

Fig. 1 is a circuit diagram showing a configuration of a semiconductor device 1 in accordance with an embodiment 1. The semiconductor device 1 is a double integration type A/D converter that has: the switches 10 and 11; the integrator 12; the comparator 13; the counter circuit 14; the calculation circuit 15; the control circuit 16; an integration time update circuit 17; and a storage circuit 18.

As described above, the semiconductor device 1 differs from the semiconductor device 9 in accordance with the comparative example in a point that the integration time update circuit 17 and the storage circuit 18 are added to the former device in addition to each configuration of the semiconductor device 9 in accordance with the comparative example. Although in the embodiment, a configuration is explained in which the storage circuit 18 that stores an output by the calculation circuit 15 is provided, the semiconductor device 1 need not necessarily store a calculation result. Therefore, when the semiconductor device 1 does not store the calculation result, the storage circuit 18 need not be provided.

In the semiconductor device 1 in accordance with the embodiment 1, the control circuit 16 controls an input to the integrator 12 so that the integrator 12 performs integration of the analog signal Van and the integrated reference voltage Vref once within a predetermined conversion period, and the integration time update circuit 17 updates the time T1 in a next conversion period based on the time T2 in a current conversion period. Hereinafter, a detailed configuration of the semiconductor device 1 will be explained.

The integration time update circuit 17 is a circuit that updates the time T1 counted by the counter circuit 14 based on the time T2 counted by the counter circuit 14. Note that a specific method of updating the time T1 in the integration time update circuit 17 will be mentioned later. The time T2 counted by the counter circuit 14 is input to the integration time update circuit 17. In addition, an output by the integration time update circuit 17, i.e., the updated time T1, is input to the counter circuit 14 and the calculation circuit 15.

When the time T1 is updated by the integration time update circuit 17, the counter circuit 14 counts an integration time of the analog signal Van by the updated time T1. When the time T1 is updated by the integration time update circuit 17, the calculation circuit 15 performs a calculation shown by the above-described Formula (4) using the updated time T1.

The storage circuit 18 is a circuit that stores an A/D conversion result obtained by the calculation by the calculation circuit 15 as mentioned above. The storage circuit 18 is, for example, a register.

In addition, the control circuit 16 outputs an on/off signal SWVan to the switch 10, and outputs an on/off signal SWVref to the switch 11. The counter circuit 14 outputs a switch switching signal S1 to the control circuit 16. The comparator 13 outputs a comparator output signal S2 to the counter circuit 14. The counter circuit 14 outputs the time T2 to the calculation circuit 15 and the integration time update circuit 17. The integration time update circuit 17 outputs the time T1 to the counter circuit 14 and the calculation circuit 15. The calculation circuit 15 outputs a measurement result S3 of the Van to the storage circuit 18.

Note that in the semiconductor device 1 shown in Fig. 1, configurations of the integrator 12 and the comparator 13 are just one example thereof, and that an other connection may instead be employed. For example, although the integrator 12 and the comparator 13 are connected to a ground GND, respectively, they may not necessarily be connected thereto. Accordingly, the comparison reference voltage is not limited to 0 V, either.

<Explanation of update of time T1>

Next, details of update of the time T1 by the integration time update circuit 17 will be explained. Note that in the following explanation, the time T1 in the Nth A/D conversion in the semiconductor device 1 is set as T1_N, and that the time T2 in the Nth A/D conversion in the semiconductor device 1 is set as T2_N. In addition, the semiconductor device 1 shall be standardized so as to end integration for one A/D conversion within a predetermined conversion period Tconv.

The integration time update circuit 17 receives the time T2_N in the Nth conversion from the counter circuit 14, updates the time T1_N in the Nth conversion, and outputs it to the counter circuit 14 and the calculation circuit 15 as a time T1_(N+1) in the (N+1)th conversion. Additionally, the counter circuit 14 counts the time T1_(N+1), which is the time T1 updated by the integration time update circuit 17, at the time of the count of the (N+1)th conversion.

Accordingly, the integrator 12 integrates the analog signal Van until the time T1_(N+1) at the time of the (N+1)th conversion. In addition, the calculation circuit 15 performs a calculation of the above-described Formula (4) using the T1_(N+1), which is the time T1 updated by the integration time update circuit 17, and a time T2_(N+1), in a calculation in the (N+1)th conversion.

The integration time update circuit 17 updates the time T1 by extending the time T1 at the time of the (N+1)th conversion according to a remaining time that has not been spent for the integration during the predetermined conversion period Tconv in the Nth conversion. Specifically, the integration time update circuit 17, for example, performs a calculation shown hereinafter, and outputs the time T1_(N+1) in the (N+1)th conversion.

The integration time update circuit 17 calculates a time coefficient $\alpha$_N that satisfies the following Formula (6), i.e., Formula (7).

$$(\text{T1\_N} + \text{T2\_N}) \times \alpha\text{\_N} \leq \text{Tconv'} \quad \ldots \quad (6)$$

$$\alpha\text{\_N} \leq \text{Tconv'}/(\text{T1\_N} + \text{T2\_N}) \quad \ldots \quad (7)$$

However, Tconv' satisfies the following relation.

$$\text{Tconv'} = \text{Tconv} - \text{Tmargin} \quad \ldots \quad (8)$$

Here, a margin period Tmargin is a predetermined period for ending the integration within the conversion period Tconv, even if the time T2_(N+1) becomes longer than the time T2_N by voltage variation of the analog signal Van between the Nth conversion and the (N+1)th conversion. As described above, the integration time update circuit 17 updates the time T1 based on a time length of a period obtained by excluding the predetermined margin period Tmargin from the conversion period Tconv. However, the Tmargin may be 0. Accordingly, as shown in Formula (6) or (7), the time coefficient $\alpha$_N can be said to be the coefficient indicating how the time T1 can be extended under a condition of ending the integration within a prescribed period, when it is assumed that the integrator 12 integrates the analog signal Van of the same voltage as that in the Nth conversion at the time of the (N+1)th conversion.

The integration time update circuit 17, for example, calculates Tconv'/(T1_N + T2_N) as the $\alpha$_N that satisfies the above-described Formula (7).

Next, the integration time update circuit 17 calculates the time T1_(N+1), which is the (N+1)th time T1, by the following Formula (9).

$$\text{T1\_(N+1)} = \alpha\text{\_N} \times \text{T1\_N} \quad \ldots \quad (9)$$

Here, when there is no change in the analog signal Van between the Nth conversion and the (N+1)th conversion, the following Formula (10) is established.

$$\text{T1\_(N+1)} + \text{T2\_(N+1)} = (\text{T1\_N} + \text{T2\_N}) \times \alpha\text{\_N} \quad \ldots \quad (10)$$

Accordingly, the following Formula (11) is shown from the above-described Formulas (6) and (10).

$$\text{T1\_(N+1)} + \text{T2\_(N+1)} \leq \text{Tconv'} < \text{Tconv} \quad \ldots \quad (11)$$

For this reason, an integration time of the (N+1)th conversion can be completed within the predetermined conversion period Tconv. In addition, even if there is a minute variation in the analog signal Van between the Nth conversion and the (N+1)th conversion, the integration time of the (N+1)th conversion can be completed within the predetermined conversion period Tconv by absorbing an increase in the integration time due to the variation in the analog signal by means of the margin period Tmargin. In this case, for example, the margin period Tmargin corresponding to the variation in the analog signal Van assumed between the Nth conversion and the (N+1) th conversion may just be set as a value used for a calculation of the integration time update circuit 17.

Note that the integration time update circuit 17, for example, outputs a predetermined initial value to the counter circuit 14 as a T1_1, which is the T1 used for the first conversion. The predetermined initial value may be the same as the time T1 used in the semiconductor device 9 in accordance with the comparative example.

<Explanation of operation of semiconductor device 1>

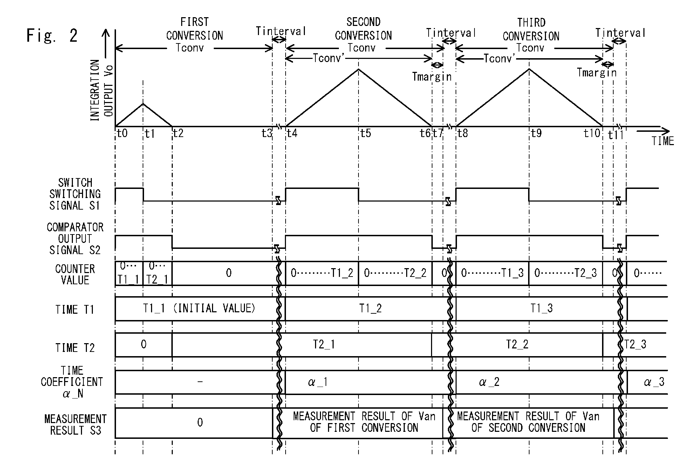

Next, the operation of the semiconductor device 1 in accordance with the embodiment 1 will be explained. Fig. 2 is a time chart showing the operation of the semiconductor device 1. Note that in Fig. 2, a waiting time Tinterval is the waiting time until the next A/D conversion is performed in the repeated A/D conversion. However, this waiting time may be 0.

First, at a time t0, the switch switching signal S1 output to the control circuit 16 from the counter circuit 14 becomes high. As a result of this, the control circuit 16 turns on the switch 10 of the analog signal Van side, and turns off the switch 11 of the integrated reference voltage Vref side. The integrator 12 integrates the analog signal Van to be input.

The counter circuit 14 performs a count operation in accordance with the time T1 output from the integration time update circuit 17. Note that the T1_1, which is the time T1 of the first conversion, is a predetermined initial value.

At a time t1, a count value of the counter circuit 14 becomes the same value as the T1_1. At the time t1, the switch switching signal S1 output to the control circuit 16 from the counter circuit 14 becomes low. As a result of this, the control circuit 16 turns off the switch 10 of the analog signal Van side, and turns on the switch 11 of the integrated reference voltage Vref side.

The integrator 12 integrates the integrated reference voltage Vref to be input. The comparator 13 compares an output of the integrator 12 and the comparison reference voltage (0 V), and outputs the comparator output signal S2 to the counter circuit 14. Note that the comparator output signal S2 output by the comparator 13 is high until the output of the integrator 12 reaches the comparison reference voltage, and that it becomes low when the output of the integrator 12 reaches the comparison reference voltage.

The counter circuit 14 counts a time T2_1 until the comparator output signal S2 becomes low from the time t1.

At a time t2, the comparator output signal S2 becomes low. The counter circuit 14 outputs the time T2_1 to the calculation circuit 15 and the integration time update circuit 17.

When the time T2_1 is output from the counter circuit 14, the calculation circuit 15 performs the calculation of the above-described Formula (4) using the times T1_1 and T2_1, and outputs a calculation result to the storage circuit 18. As a result of this, the storage circuit 18 stores a measurement result of the analog signal Van of the first conversion.

Meanwhile, when the time T2_1 is output from the counter circuit 14, the integration time update circuit 17 calculates a time coefficient $\alpha$_1, and further calculates a time T1_2 from the time coefficient $\alpha$_1. The integration time update circuit 17 outputs the calculated time T1_2 to the counter circuit 14 and the calculation circuit 15.

At a time 3, the conversion period Tconv in the first A/D conversion ends. Additionally, at a time t4, the second A/D conversion is started after the waiting time Tinterval until the next A/D conversion. In the second A/D conversion, integration of the analog signal Van, calculation of a result of measuring the analog signal Van of the second conversion, and calculation of a time T1_3 in the third A/D conversion are performed using the T1_2, which is the time T1 updated by the integration time update circuit 17.

After that, A/D conversion is similarly repeated. As described above, the (N+1)th A/D conversion is performed using the time T1 calculated by the integration time update circuit 17 at the time of the Nth A/D conversion. In so doing, as shown in Fig. 2, a time when integration is performed by the integrator 12 ends within the conversion period Tconv in A/D conversion of each time.

<Explanation of integration time>

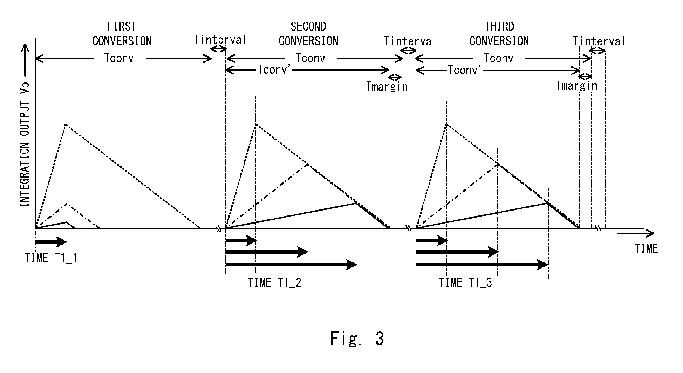

Fig. 3 is a graph showing differences in integration times for each potential of the analog signal Van in the semiconductor device 1. Note that in the graph shown in Fig. 3, a dashed line denotes an integration output when the analog signal Van of a maximum potential is input to the integrator 12, a continuous line denotes an integration output when the analog signal Van of a minimum potential is input to the integrator 12, and that an alternate long and short dash line denotes an integration output when the analog signal Van of a potential between the maximum potential and the minimum potential is input to the integrator 12.

As shown in Fig. 3, although in the first conversion, the integration time T1_1 of the analog signal Van is constant even with respect to the analog signal Van of any potential, after the second conversion, the lower the potential of the analog signal Van is, the longer the integration time T1 of the analog signal Van is. In addition, after the second conversion, total integration times of the analog signal Van and the integrated reference voltage Vref are substantially the same regardless of the potential of the analog signal Van. As described above, the semiconductor device 1 performs integration by the integrator 12 for a time as much as possible within the conversion period Tconv regardless of the potential of the analog signal Van.

<Explanation of conversion error>

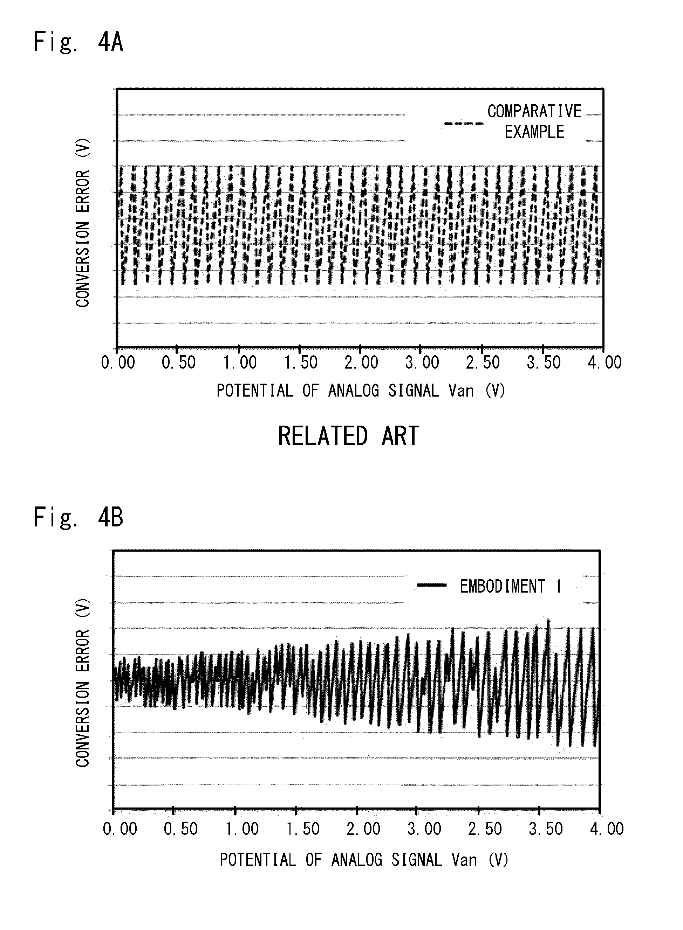

Figs. 4A and 4B are graphs showing conversion errors of the A/D converter, Fig. 4A shows the conversion errors of the semiconductor device 9 in accordance with the above-mentioned comparative example, and Fig. 4B shows the conversion errors of the semiconductor device 1 in accordance with the embodiment. As shown in Figs. 4A and 4B, the semiconductor device 1 in accordance with the embodiment has conversion accuracy which is more improved compared with that of the semiconductor device 9 in accordance with the comparative example as the potential of the analog signal Van becomes lower.

The semiconductor device 1 in accordance with the embodiment updates the time T1 so as to extend the time T1 at the time of the (N+1)th conversion according to the remaining time that has not been spent for the integration during the predetermined conversion period Tconv in the Nth conversion as mentioned above. For this reason, the semiconductor device 1 can use the conversion period Tconv more effectively compared with the semiconductor device 9 in accordance with the comparative example.

When the analog signal Van is integrated by the semiconductor device 9 in accordance with the comparative example, the number of clocks to sample the analog signal Van becomes constant since the integration time of the analog signal Van is constant regardless of the potential of the analog signal. In contrast with this, in the semiconductor device 1 in accordance with the embodiment, the integration time of the analog signal Van is set to be as long as possible within a range in which the integration times of the analog signal Van and the integrated reference voltage Vref do not exceed the conversion period Tconv. For this reason, in the semiconductor device 1 in accordance with the embodiment, the lower the potential of the analog signal Van is, the longer the integration time becomes. Additionally, as the integration time of the analog signal Van becomes longer, the number of clocks to sample the analog signal Van increases, and thus conversion accuracy of analog-to-digital conversion can be improved. Particularly, when the potential of the analog signal Van is comparatively low, the number of clocks to sample the analog signal Van remarkably increases, and thus the conversion accuracy of the analog-to-digital conversion can be remarkably improved.

<Embodiment 2>

Next, an onboard system using the semiconductor device shown as the embodiment 1 will be explained as an embodiment 2.

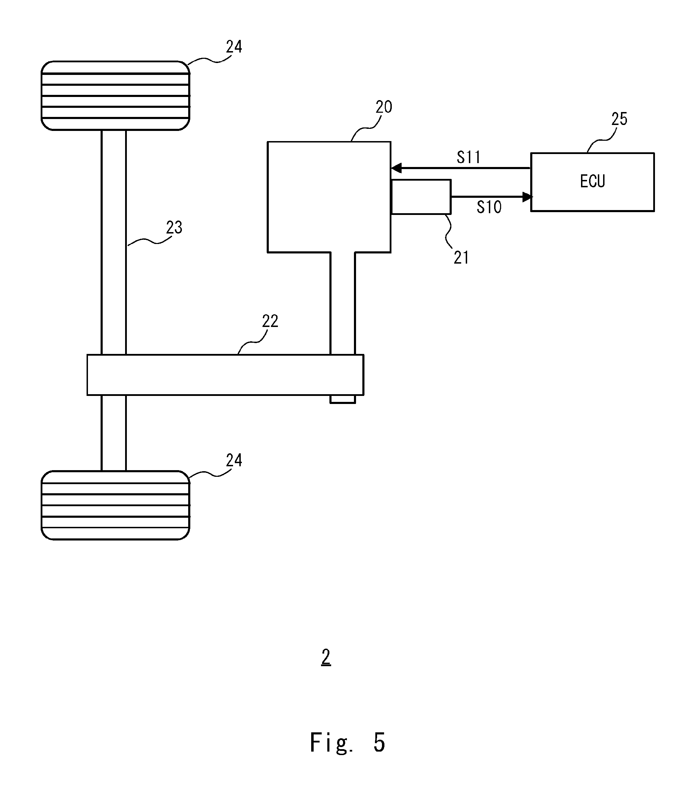

Fig. 5 is a schematic view showing a configuration of a vehicle 2 in which an onboard system 3 that will be mentioned later has been mounted. The vehicle 2 includes: an engine 20; a detection unit 21; a reducer 22; a drive shaft 23; drive wheels 24; and an ECU (Electronic Control Unit) 25.

The vehicle 2 travels by rotation of the drive wheels 24 by means of a drive force from the engine 20.

The engine 20 burns fuel, and transmits energy obtained by the burnt fuel to the drive shaft 23 through the reducer 22.

The detection unit 21 is a sensor that detects a state of the vehicle 2, and detects a state related to the engine 20 in the embodiment. More specifically, the detection unit 21 detects an intake air temperature, an exhaust gas temperature, an engine cooling water temperature, etc. of the engine 20. The detection unit 21 outputs a detected state signal S10 to the ECU 25.

The ECU 25 generates a control signal S11 that controls the engine 20 based on the state detected by the detection unit 21, and outputs the control signal S11 to the engine 20. The engine 20 operates based on the control signal S11 output by the ECU 25. For example, the engine 20 operates in accordance with a fuel injection amount, ignition timing, etc. determined based on the control signal S11.

<Explanation of configuration of onboard system 3>

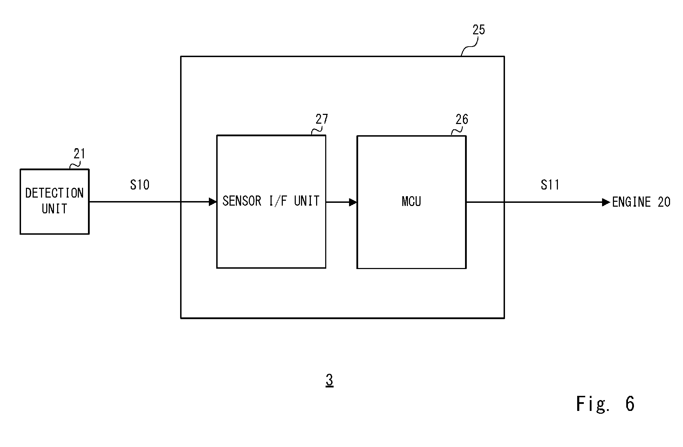

Fig. 6 is a block diagram showing a summary of a configuration of the onboard system 3. The onboard system 3 has the above-mentioned detection unit 21 and ECU 25. The onboard system 3 measures a state value indicating a state of the vehicle 2, and controls the vehicle 2 based on the measured state value. Specifically, the onboard system 3 measures a temperature of the engine 20, and controls the engine 20 based on the measured temperature.

The ECU 25 has an MCU 26 and a sensor interface unit (a sensor I/F unit) 27. The MCU 26 is a microcontroller (a control unit) that includes a central processing circuit (a processor unit), a memory unit, etc., and performs generation etc. of the control signal S11 that controls the engine 20.

The sensor I/F unit 27 is a semiconductor device including an A/D converter that converts an analog signal input from the detection unit 21 into a digital value. Namely, the sensor I/F unit 27 performs a calculation of the digital value of the analog signal (the state signal S10), which is a detection result by the detection unit 21, and measures the state value of the vehicle 2.

The MCU 26 obtains the digital value of the state detected by the detection unit 21 from the sensor I/F unit 27, and generates the control signal S11. As described above, the MCU 26 controls the vehicle 2 based on the state value measured by the sensor I/F unit 27.

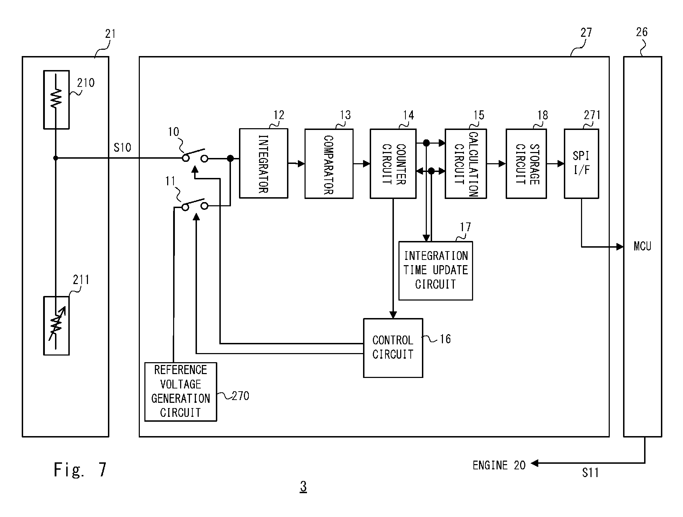

Fig. 7 is a block diagram showing a detailed configuration of the onboard system 3. The detection unit 21 is a sensor that detects the temperatures related to the engine, and has a reference resistor 210 and a thermistor 211. Here, an electric resistance of the thermistor 211, for example, changes according to the engine intake air temperature. By such configuration, the detection unit 21 outputs the state signal S10, which is an analog signal (a voltage), to the ECU 25 according to a detection result.

The sensor I/F unit 27 has a configuration including the semiconductor device 1 in accordance with the embodiment 1. Namely, the sensor I/F unit 27 includes: the above-mentioned switches 10 and 11, integrator 12, comparator 13, counter circuit 14, calculation circuit 15, control circuit 16, integration time update circuit 17, and storage circuit 18. In addition, the sensor I/F unit 27 further has a reference voltage generation circuit 270 that generates the integrated reference voltage Vref, and an SPI (Serial Peripheral Interface) I/F 271 that is a communication interface for inputting and outputting data between the storage circuit 18 and the MCU 26. In addition, one terminal of the switch 10 is connected to an input of the integrator 12, and an other terminal thereof is connected to an output of the detection unit 21. In addition, one terminal of the switch 11 is connected to the input of the integrator 12, and an other terminal thereof is connected to an output of the reference voltage generation circuit 270.

By the configuration described above, the onboard system 3 detects the temperature of the engine 20 in the detection unit 21, performs A/D conversion of the state signal S10, which is the analog signal of the temperature detected by the sensor I/F unit 27, and thereby measures the temperature of the engine 20. The MCU 26 of the onboard system 3 then generates the control signal S11 based on the measured temperature, and controls the engine 20.

Here, A/D conversion similar to the semiconductor device 1 according to the above-described embodiment 1 is performed to the state of the vehicle detected as the analog signal by the detection unit 21. Accordingly, an integration time by the integrator 12 of the analog signal detected by the detection unit 21 is set to be as long as possible within a range in which integration times of the analog signal and the integrated reference voltage Vref do not exceed the conversion period Tconv. For this reason, compared with a case where the time T1 is set to be constant regardless of the potential of the analog signal, the number of clocks to sample the analog signal increases, and thus conversion accuracy of analog-to-digital conversion can be improved. Namely, accuracy of measurement of the state value of the vehicle can be improved. Accordingly, since being able to generate the control signal S11 using the state value in which an error has been suppressed, the MCU 26 can perform accurate control corresponding to the state of the vehicle 2. Specifically, the MCU 26, for example, can accurately control a fuel injection amount, ignition timing, etc. of the engine 20 according to the state of the engine 20.

Note that although the state of the engine 20 has been exemplified as the state of the vehicle 2 in the explanation of the embodiment, this is merely one example. For example, the onboard system 3 may measure states of the reducer 22, a brake (not shown), and a vehicle air conditioner (not shown) instead of the engine 20, and may control them based on measurement results. In addition, a target to be measured is not limited to temperature and, for example, may be a fluid volume, weight, etc.

<Embodiment 3>

Next, an embodiment 3 will be explained.

In the semiconductor device 1 in accordance with the embodiment 1, the control circuit 16 controls the input to the integrator 12 so that the integrator 12 performs the integration of the analog signal Van and the integrated reference voltage Vref once within the predetermined conversion period Tconv, and the integration time updating circuit 17 updates the time T1 in the next conversion period Tconv based on the time T2 in the current conversion period Tconv. Namely, in the semiconductor device 1, the time T1 of the (N+1)th A/D conversion is decided based on the time T2 at the time of the Nth A/D conversion, in the repeated A/D conversion.

In contrast with this, in a semiconductor device 4 in accordance with the embodiment 3, the control circuit 16 controls an input to the integrator 12 so that the integrator 12 performs integration of the analog signal Van and the integrated reference voltage Vref twice within the predetermined conversion period Tconv, and an integration time update circuit 42, which will be mentioned later, updates the second time T1 within the conversion period Tconv based on the first time T2 within the conversion period Tconv. That is, in the semiconductor device 4, the time T1 is calculated within the one-time conversion period Tconv, and the analog signal Van is integrated using the time T1 within the conversion period Tconv.

Specifically, the semiconductor device 4 in accordance with the embodiment 3 divides the conversion period Tconv into a pre-integration period Tpre and a main integration period Tmain, and integrates the analog signal Van in each of these integration periods. Namely, the semiconductor device 4 first integrates the analog signal Van and the integrated reference voltage Vref within the pre-integration period Tpre, and integrates the analog signal Van and the integrated reference voltage Vref also within the subsequent main integration period Tmain. Here, the semiconductor device 4 decides an integration time of the analog signal Van within the main integration period Tmain using an integration result in the pre-integration period Tpre.

<Explanation of configuration of semiconductor device in accordance with embodiment 3>

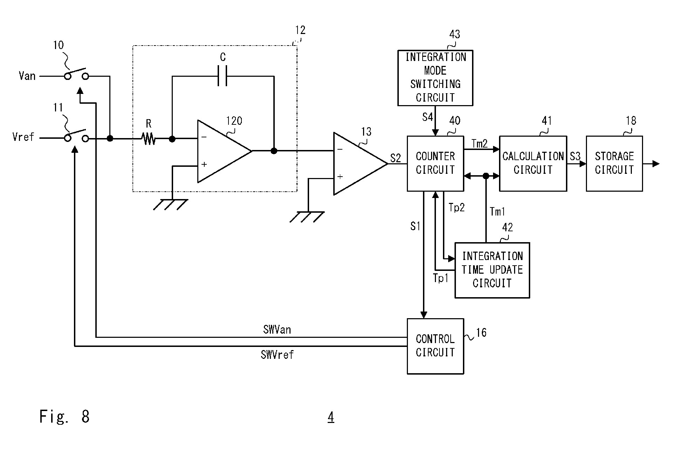

Fig. 8 is a circuit diagram showing a configuration of the semiconductor device 4 in accordance with the embodiment 3. The semiconductor device 4 is a double integration type A/D converter that has: the switches 10 and 11; the integrator 12; the comparator 13; the control circuit 16; a counter circuit 40; a calculation circuit 41; the integration time update circuit 42; an integration mode switching circuit 43; and the storage circuit 18.

As described above, the semiconductor device 4 differs from the embodiment 1 in the point that the counter circuit 14, the calculation circuit 15, and the integration time update circuit 17 of the semiconductor device 1 in accordance with the embodiment 1 are replaced with the counter circuit 40, the calculation circuit 41, and the integration time update circuit 42, respectively, and the integration mode switching circuit 43 is added. Note that although a configuration in which the storage circuit 18 has been provided is explained also in the embodiment, the semiconductor device 4 need not necessarily store a calculation result. Therefore, when the semiconductor device 4 does not store the calculation result, the storage circuit 18 need not be provided.

Hereinafter, a point in which the semiconductor device 4 differs from the semiconductor device 1 in accordance with the embodiment 1 will be explained.

The integration mode switching circuit 43 switches the pre-integration period Tpre and the main integration period Tmain within one conversion period Tconv. Specifically, the integration mode switching circuit 43 divides a period obtained by excluding the above-mentioned margin period Tmargin from the predetermined conversion period Tconv into the pre-integration period Tpre and the main integration period Tmain. However, the pre-integration period Tpre is a period shorter than the main integration period Tmain. In the semiconductor device 4 in accordance with the embodiment, integration for calculating the time T1 at the time of A/D conversion is performed in the pre-integration period Tpre, and actual A/D conversion is performed in the main integration period Tmain. Accordingly, the main integration period Tmain is preferably as long as possible with respect to the pre-integration period Tpre in order to secure the number of samplings at the time of A/D conversion. For this reason, as shown in the following Formula (12), the pre-integration period Tpre is preferably sufficiently shorter than the main integration period Tmain.

$$\text{pre-integration period Tpre} \ll \text{main integration period Tmain}$$
$$\ldots (12)$$

The integration mode switching circuit 43 outputs a signal indicating the pre-integration period Tpre to the counter circuit 40 at the time of the start of the conversion period Tconv. In addition, when the pre-integration period Tpre ends, the integration mode switching circuit 43 outputs a signal indicating the main integration period Tmain to the counter circuit 40.

Similarly to the counter circuit 14, the counter circuit 40 counts the times T1 and T2. However, the counter circuit 40 counts the times T1 and T2 in the pre-integration period Tpre based on the signal from the integration mode switching circuit 43, and subsequently, counts the times T1 and T2 also in the main integration period Tmain. Accordingly, the counter circuit 40 counts the times T1 and T2 twice within the one conversion period Tconv. Note that the counter circuit 40 counts the time T1 specified by the integration time update circuit 42.

The integration time update circuit 42 is the circuit that updates the time T1 based on the time T2 of the pre-integration period Tpre counted by the counter circuit 40. More specifically, the integration time update circuit 42 calculates the time T1 counted by the counter circuit 40 in the main integration period Tmain based on the time T2 of the pre-integration period Tpre. The time T2 of the pre-integration period Tpre counted by the counter circuit 40 is input to the integration time update circuit 42. In addition, an output by the integration time update circuit 42, i.e., the time T1 used in the main integration period Tmain, is input to the counter circuit 40 and the calculation circuit 41. In addition, the integration time update circuit 42 outputs the time T1 of the pre-integration period Tpre to the counter circuit 40.

<Explanation of update of time T1>

Next, details of update of the time T1 by the integration time update circuit 42 will be explained. Note that in the following explanation, each reference character is defined as follows:

Tp1_N: a time T1 of the pre-integration period Tpre in the Nth conversion;
Tp2_N: a time T2 of the pre-integration period Tpre in the Nth conversion;
Tm1_N: a time T1 of the main integration period Tmain in the Nth conversion; and
Tm2_N: a time T2 of the main integration period Tmain in the Nth conversion.

Note that although the Tp1_N is explained as being a fixed value regardless of the number of conversions N, the present invention is not limited to this. For example, the Tp1_N may be a predetermined value different for each conversion.
The integration time update circuit 42 receives the time Tp2_N in the Nth conversion from the counter circuit 40, calculates the time Tm1_N in the Nth conversion, and outputs it to the counter circuit 40 and the calculation circuit 41. The integration time update circuit 42 updates the time T1 so as to extend the time T1 at the time of conversion in the main integration period Tmain according to the integration time in the pre-integration period Tpre (according to lack of the integration time). Specifically, for example, the integration time update circuit 42 performs a calculation shown hereinafter, and outputs the time Tm1_N in the main integration period Tmain.
The integration time update circuit 42 calculates a time coefficient α_N that satisfies the following Formula (13), i.e., Formula (14).

$$\text{(Tp1\_N + Tp2\_N)} \times \alpha\_N \le \text{Tmain} \ \ldots \ (13)$$

$$\alpha\_N \le \text{Tmain/(Tp1\_N + Tp2\_N)} \ \ldots \ (14)$$

However, the Tmain satisfies the following relation.

$$\text{Tmain = Tconv - Tpre - Tmargin} \ \ldots \ (15)$$

Note that the Tmargin may be 0. Accordingly, as shown in Formula (13) or (14), the time coefficient α_N can be said to be the coefficient indicating how the time T1 can be extended under a condition of ending integration within the main integration period Tmain.
The integration time update circuit 42, for example, calculates Tmain/(Tp1_N + Tp2_N) as the α_N that satisfies the above-described Formula (14).
Next, the integration time update circuit 42 calculates the time Tm1_N, which is the time T1 in the main integration period Tmain, by the following Formula (16).

$$\text{Tm1\_N} = \alpha\_N \times \text{Tp1\_N} \ \ldots \ (16)$$

Since the conversion period Tconv is sufficiently shorter compared with a speed of variation of the analog signal Van, it can be considered that there is no variation of the analog signal Van within the one conversion period Tconv. For this reason, a potential of the analog signal Van is substantially constant in the pre-integration period Tpre and the main integration period Tmain. Accordingly, the following Formula (17) is established.

$$\text{Tm1\_N + Tm2\_N = (Tp1\_N + Tp2\_N)} \times \alpha\_N \ \ldots \ (17)$$

Consequently, the following Formula (18) is shown from the above-described Formulas (13) and (17).

$$\text{Tm1\_N + Tm2\_N} \le \text{Tmain < Tconv} \ \ldots \ (18)$$

For this reason, an integration time of the Nth conversion is completed within the predetermined conversion period Tconv.

The Tm1_N calculated by the integration time update circuit 42 and the Tm2_N counted by the counter circuit 40 are input to the calculation circuit 41. The calculation circuit 41 performs a calculation shown in the following Formula (19), and outputs an A/D conversion result.

$$Van = -Vref \times (Tm2\_N/Tm1\_N) \ ... \ (19)$$

<Explanation of operation of semiconductor device 4>

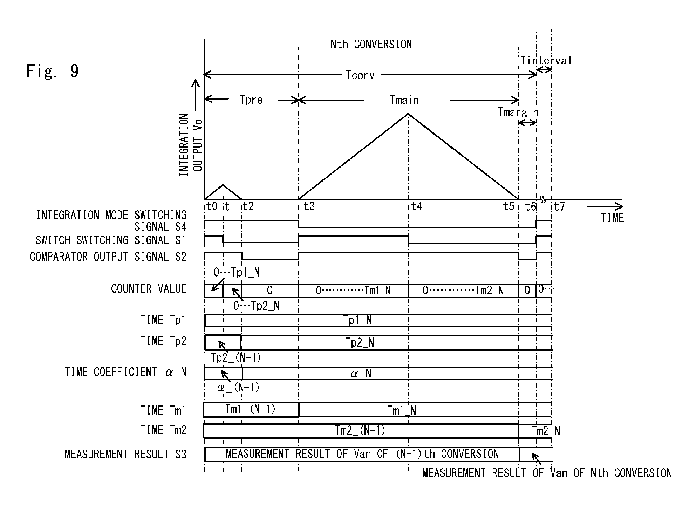

Next, operation of the semiconductor device 4 in accordance with the embodiment 3 will be explained. Fig. 9 is a time chart showing the operation of the semiconductor device 4 at the time of the Nth conversion. Note that in the following explanation, the semiconductor device 4 will be explained as being a device that performs the following input and output of a signal as shown in Figs. 8 and 9. The control circuit 16 outputs the on/off signal SWVan to the switch 10, and outputs the on/off signal SWVref to the switch 11. The counter circuit 40 outputs the switch switching signal S1 to the control circuit 16. The comparator 13 outputs the comparator output signal S2 to the counter circuit 40. The counter circuit 40 outputs a time Tp2, which is the time T2 of the pre-integration period Tpre, to the integration time update circuit 42, and outputs a time Tm2, which is the time T2 of the main integration period Tmain, to the calculation circuit 41. In addition, the integration time update circuit 42 outputs a time Tp1, which is the time T1 of the pre-integration period Tpre, to the counter circuit 40, and outputs a time Tm1, which is the time T1 of the main integration period Tmain, to the counter circuit 40 and the calculation circuit 41. The calculation circuit 41 outputs the measurement result S3 of the Van to the storage circuit 18. The integration mode switching circuit 43 outputs an integration mode switching signal S4 to the counter circuit 40.

First, at a time t0, which is a start time of the Nth conversion, the integration mode switching signal S4 output from the integration mode switching circuit 43 becomes high, and integration of the pre-integration period Tpre is performed. Specifically, the following operation is performed in association with the integration mode switching signal S4 becoming high. The switch switching signal S1 output to the control circuit 16 from the counter circuit 40 becomes high. As a result of this, the control circuit 16 turns on the switch 10 of the analog signal Van side, and turns off the switch 11 of the integrated reference voltage Vref side. The integrator 12 integrates the analog signal Van to be input.

The counter circuit 40 performs a count operation in accordance with the time Tp1_N output from the integration time update circuit 42.

At a time t1, a count value of the counter circuit 40 becomes the same value as the Tp1_N. At the time t1, the switch switching signal S1 output to the control circuit 16 from the counter circuit 40 becomes low. As a result of this, the control circuit 16 turns off the switch 10 of the analog signal Van side, and turns on the switch 11 of the integrated reference voltage Vref side. The integrator 12 integrates the integrated reference voltage Vref to be input. The comparator 13 compares an output of the integrator 12 and the comparison reference voltage (0 V), and outputs the comparator output signal S2 to the counter circuit 40. Note that the comparator output signal S2 output by the comparator 13 is high until the output of the integrator 12 reaches the comparison reference voltage, and that it becomes low when the output of the integrator 12 reaches the comparison reference voltage.

The counter circuit 40 counts the time Tp2_N until the comparator output signal S2 becomes low from the time t1.

At a time t2, the comparator output signal S2 becomes low. The counter circuit 40 outputs the time Tp2_N to the integration time update circuit 42.

When the time Tp2_N is output from the counter circuit 40, the integration time update circuit 42 calculates the time coefficient $\alpha\_N$, and further calculates the time Tm1_N from the time coefficient $\alpha\_N$. The integration time update circuit 42 outputs the calculated time Tm1_N to the counter circuit 40 and the calculation circuit 41.

When the pre-integration period Tpre ends at a time t3, the integration mode switching signal S4 output from the integration mode switching circuit 43 becomes low, and integration of the main integration period Tmain is performed. Specifically, the following operation is performed in association with the integration mode switching signal S4 becoming low. The switch switching signal S1 output to the control circuit 16 from the counter circuit 40 becomes high. As a result of this, the control circuit 16 turns on the switch 10 of the analog signal Van side, and turns off the switch 11 of the integrated reference voltage Vref side. The integrator 12 integrates the analog signal Van to be input.

The counter circuit 40 performs a count operation in accordance with the time Tm1_N output from the integration time update circuit 42.

At a time t4, the count value of the counter circuit 40 becomes the same value as the Tm1_N. At the time t4, the switch switching signal S1 output to the control circuit 16 from the counter circuit 40 becomes low. As a result of this, the control circuit 16 turns off the switch 10 of the analog signal Van side, and turns on the switch 11 of the integrated reference voltage Vref side. The integrator 12 integrates the integrated reference voltage Vref to be input. The comparator 13 compares an output of the integrator 12 and the comparison reference voltage (0 V), and outputs the comparator output signal S2 to the counter circuit 40.

The counter circuit 40 counts the time Tm2_N until the comparator output signal S2 becomes low from the time t4.

At a time t5, the comparator output signal S2 becomes low. The counter circuit 40 outputs the time Tm2_N to the calculation circuit 41.

When the time Tm2_N is output from the counter circuit 40, the calculation circuit 41 performs a calculation of the above-described Formula (19) using the time Tm2_N and the time Tm1_N output from the integration time update circuit 42, and outputs a calculation result to the storage circuit 18. As a result of this, the storage circuit 18 stores a measurement result of the analog signal Van of the Nth conversion.

At a time 6, the conversion period Tconv in the Nth A/D conversion ends. Additionally, at a time t7, the (N+1)th A/D conversion is started after the waiting time Tinterval until the (N+1)th A/D conversion. According to such a manner as described above, the semiconductor device 4 repeats A/D conversion.

<Explanation of integration time in semiconductor device 4>

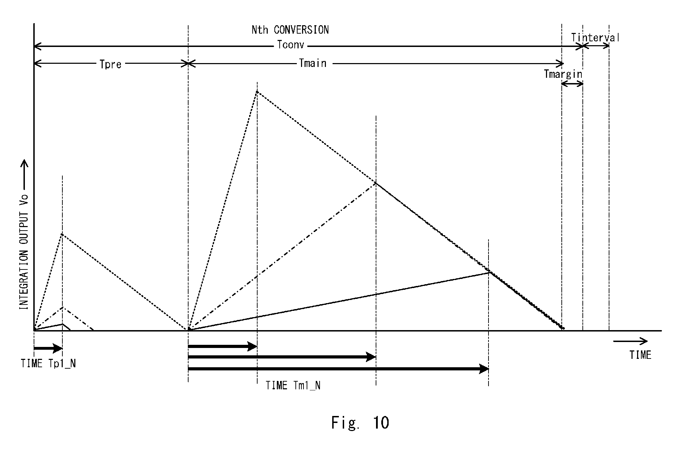

Fig. 10 is a graph showing differences in integration times for each potential of the analog signal Van in the semiconductor device 4 in accordance with the embodiment 3. Note that in the graph shown in Fig. 10, a dashed line denotes an integration output when the analog signal Van of a maximum potential is input to the integrator 12, a continuous line denotes an integration output when the analog signal Van of a minimum potential is input to the integrator 12, and that an alternate long and short dash line denotes an integration output when the analog signal Van of a potential between the maximum potential and the minimum potential is input to the integrator 12.

As shown in Fig. 10, although in the integration in the pre-integration period Tpre, the integration time Tp1_N of the analog signal Van is constant with respect to the analog signal Van of any potential, in the integration in the main integration period Tmain, the lower the potential of the analog signal Van is, the longer the integration time Tm1_N of the analog signal Van is. In addition, in the main integration period Tmain, total integration times of the analog signal Van and the integrated reference voltage Vref are substantially the same regardless of the potential of the analog signal Van. As described above, the semiconductor device 4 performs integration by the integrator 12 for a time as much as possible within the main integration period Tmain regardless of the potential of the analog signal Van.

The semiconductor device 4 in accordance with the embodiment updates the time T1 so as to extend the time T1 at the time of conversion in the main integration period Tmain according to the integration time in the pre-integration period Tpre as mentioned above. Namely, in the semiconductor device 4 in accordance with the embodiment, the integration time of the analog signal Van in the main integration period Tmain is set to be as long as possible within a range in which the integration times of the analog signal Van and the integrated reference voltage Vref do not exceed the main integration period Tmain. For this reason, in the semiconductor device 4 in accordance with the embodiment, the lower the potential of the analog signal Van is, the longer the integration time in the main integration period Tmain becomes. Additionally, as the integration time of the analog signal Van becomes longer, the number of clocks to sample the analog signal Van increases, and thus conversion accuracy of analog-to-digital conversion can be improved. Particularly, when the potential of the analog signal Van is comparatively low, the number of clocks to sample the analog signal Van remarkably increases, and thus the conversion accuracy of the analog-to-digital conversion can be remarkably improved.

In addition, the semiconductor device 4 in accordance with the embodiment 3 has the following further advantages. In the semiconductor device 1 in accordance with the embodiment 1, a configuration is employed in which improvement in conversion accuracy can be expected in the second or later A/D conversion. In contrast with this, in the semiconductor device 4 in accordance with the embodiment 3, since calculation of the integration time T1 of the analog signal Van and integration in the integration time T1 are performed within the one conversion period Tconv, improvement in conversion accuracy can be expected from the first A/D conversion.

In addition, in the semiconductor device 1 in accordance with the embodiment 1, even if some variations of the analog signal Van occur during the waiting time Tinterval until next A/D conversion, the integration time does not exceed the conversion period Tconv because of the presence of the margin period Tmargin. However, when the variation of the analog signal Van is larger than the variation corresponding to the set margin period Tmargin in the semiconductor device 1, integration might not be ended within the conversion period Tconv. In contrast with this, in the semiconductor device 4 in accordance with the embodiment 3, the potential of the analog signal Van is substantially constant in the one conversion period Tconv as mentioned above. Accordingly, according to the semiconductor device 4 in accordance with the embodiment 3, integration can be ended during the conversion period Tconv regardless of the presence/absence of variation of the analog signal Van during the waiting time Tinterval.

<Embodiment 4>

Next, an onboard system 5 using the semiconductor device shown as the embodiment 3 will be explained as an embodiment 4. Note that the onboard system in accordance with the embodiment is the onboard system mounted in the above-mentioned vehicle 2, and differs from the onboard system 3 shown in the embodiment 2 in the following points. Hereinafter, the points different from the onboard system 3 shown in the embodiment 2 will be explained, and explanation of a configuration similar to the configuration in relation to the onboard system 3 shown in the embodiment 2 will be omitted.

<Explanation of configuration of onboard system 5>

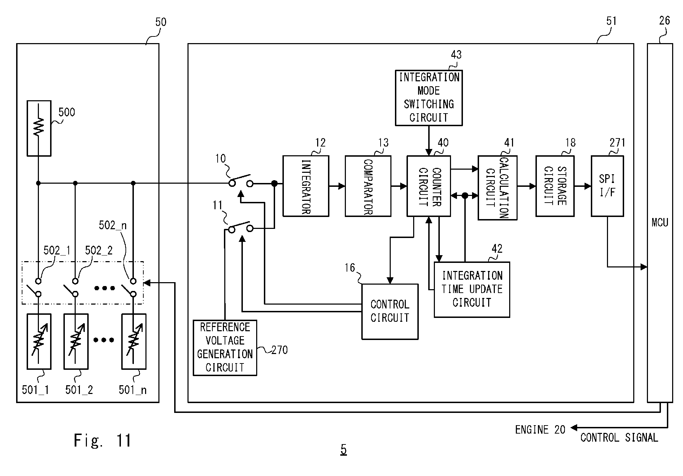

Fig. 11 is a block diagram showing a detailed configuration of the onboard system 5. As shown in Fig. 11, in the onboard system 5 in accordance with the embodiment, the detection unit 21 is replaced with a detection unit 50, and the sensor I/F unit 27 is replaced with a sensor I/F unit 51, respectively.

Unlike the detection unit 21, the detection unit 50 includes a plurality of sensors that detect temperatures related to the engine. Specifically, the detection unit 50 has a reference resistor 500, and thermistors 501_1 to 501_n (however, n is an integer not less than 2). Here, detection targets of the thermistors 501_1 to 501_n are different, respectively. For example, the thermistor 501_1 detects an intake air temperature of the engine 20, the thermistor 501_2 detects an exhaust gas temperature thereof, and the thermistor 501_n detects an engine cooling water temperature thereof. In addition, switches 502_1 to 502_n are connected to the respective thermistors 501_1 to 501_n. The detection unit 50 detects the temperature as the detection target of the thermistor connected to any switch turned on by control of the MCU 26 among the switches 502_1 to 502_n.

While the sensor I/F unit 27 in accordance with the embodiment 2 has the configuration including the semiconductor device 1 in accordance with the embodiment 1, the sensor I/F unit 51 has a configuration including the semiconductor device 4 in accordance with the embodiment 3. Namely, the sensor I/F unit 51 includes: the above-mentioned switches 10 and 11, integrator 12, comparator 13, counter circuit 40, calculation circuit 41, control circuit 16, integration time update circuit 42, integration mode switching circuit 43, and storage circuit 18. In addition, the sensor I/F unit 51 has the reference voltage generation circuit 270 and the SPI I/F 271 similarly to the sensor I/F unit 27 in accordance with the embodiment 2.

The MCU 26 sequentially controls the switches 502_1 to 502_n to be turned on. At this time, when turning on any of the switches 502_1 to 502_n, the MCU 26 turns off the other switches. In addition, the MCU 26 repeats this control to the switches 502_1 to 502_n. Accordingly, the respective switches 502_1 to 502_n are periodically turned on.

Consequently, an analog signal of sequentially selected one detection target is input to the sensor I/F unit 51. Additionally, the sensor I/F unit 51 sequentially calculates digital values of the analog signals of the plurality of detection targets.

<Explanation of A/D conversion operation in onboard system 5>

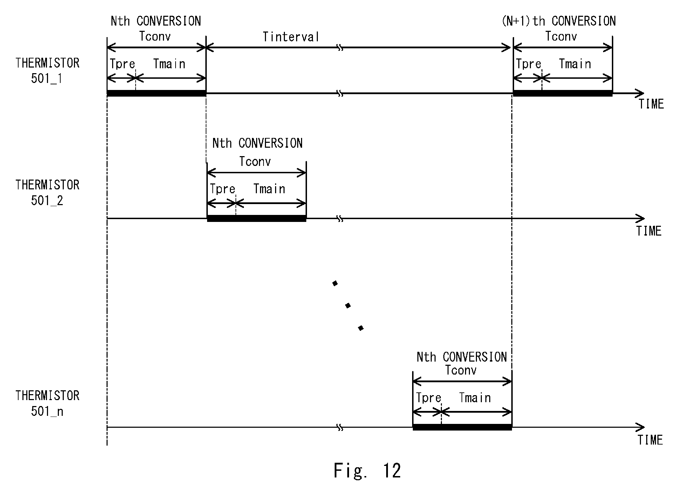

Fig. 12 is a time chart showing A/D conversion performed by the sensor I/F unit 51. Note that in Fig. 12, illustration of the margin period Tmargin is omitted for simplifying explanation. As shown in Fig. 12, the sensor I/F unit 51 sequentially performs A/D conversion to inputs from the thermistors 501_1 to 501_n. At this time, after the Nth conversion of a certain thermistor is ended and before next conversion to the thermistor is started, conversion to the other thermistors is performed. For example, the Nth conversion of the thermistors 501_2 to 501_n is performed during the waiting time Tinterval until the next (N+1)th conversion is started after the Nth conversion of the thermistor 501_1 is ended. For this reason, it is assumed that a potential of the analog signal input from the thermistor 501_1 varies at the time of the Nth conversion and the (N+1)th conversion.

However, since calculation and utilization of the integration time T1 of the analog signal Van are performed within the one conversion period Tconv similarly to the A/D conversion by the semiconductor device 4 in accordance with the above-described embodiment 3 in the A/D conversion performed by the sensor I/F unit 51, integration can be ended during the conversion period Tconv, even if variation of the analog signal Van occurs during the waiting time Tinterval.

By such a configuration, the onboard system 5 detects the plurality of detection targets in the detection unit 50, performs A/D conversion of the analog signals of the detected targets, and thereby measures the detection targets. The MCU 26 of the onboard system 5 then generates a control signal based on measurement results, and controls the engine 20.

Here, according to the A/D conversion performed by the sensor I/F unit 51, conversion accuracy of analog-to-digital conversion can be improved similarly to the A/D conversion by the semiconductor device 4 in accordance with the above-described embodiment 3. In addition, since calculation of the integration time T1 of the analog signal Van and integration in the integration time T1 are performed within the one conversion period Tconv, improvement in conversion accuracy can be expected from the first A/D conversion. In addition, since as mentioned above, integration can be ended during the conversion period Tconv even if variation of the analog signal Van occurs during the waiting time Tinterval, the measurement results of the plurality of detection targets can be obtained by one A/D converter. This contributes to reduction in size and cost of the onboard system.

Consequently, according to the onboard system 5, since the control signal that controls the vehicle 2 can be generated based on the highly accurate measurement results of a plurality of state values of the vehicle 2, accurate control corresponding to the state of the vehicle 2 can be performed. In addition, since in so doing, improvement in conversion accuracy can be expected from the first A/D conversion, accurate control corresponding to the state of the vehicle 2 can be early performed.

Note that although the temperature related to the engine 20 has been exemplified as the state of the vehicle 2 in the explanation of the embodiment, this is merely one example. Similarly to the embodiment 2, for example, the onboard system 5 may measure states of the reducer 22, the brake (not shown), and the vehicle air conditioner (not shown) instead of the engine 20, and may control them based on measurement results. In addition, a target to be measured is not limited to temperature and, for example, may be a fluid volume, weight, etc.

Hereinbefore, although the invention made by the present inventor has been specifically explained based on the embodiments, the present invention is not limited to the already mentioned embodiments, and it is needless to say that various changes can be made without departing from the scope of the invention.

For example, although in the embodiment 2, the sensor I/F unit 27 has been explained to have the configuration including the semiconductor device 1 in accordance with the embodiment 1, a configuration including the semiconductor device 4 in accordance with the embodiment 3 may be employed instead of the above configuration. Similarly, although in the embodiment 4, the sensor I/F unit 51 has been explained to have the configuration including the semiconductor device 4 in accordance with the embodiment 3, a configuration including the semiconductor device 1 in accordance with the embodiment 1 may be employed instead of the above configuration.

The first to fourth embodiments can be combined as desirable by one of ordinary skill in the art.

While the invention has been described in terms of several embodiments, those skilled in the art will recognize that the invention can be practiced with various modifications within the spirit and scope of the appended claims and the invention is not limited to the examples described above.

Further, the scope of the claims is not limited by the embodiments described above.

Furthermore, it is noted that, Applicant's intent is to encompass equivalents of all claim elements, even if amended later during prosecution.

## Claims

1. A semiconductor device comprising:

   an integrator that repeats integrating a first reference voltage after integrating an analog signal;
   a comparator that compares an output of the integrator and a second reference voltage;
   a counter circuit that counts a first integration time determined to integrate the analog signal, and a second integration time until the output of the integrator reaches the second reference voltage from start of integration of the first reference voltage;
   a calculation circuit that calculates a digital value of the analog signal based on the first and the second integration times;
   a control circuit that performs control so that the analog signal is input to the integrator while the counter circuit counts the first integration time; and
   an integration time update circuit that updates the first integration time counted by the counter circuit based on the second integration time counted by the counter circuit.

2. The semiconductor device according to Claim 1, wherein
   the control circuit controls an input to the integrator so that the integrator integrates an analog signal and a first reference voltage once within a predetermined conversion period, and
   the integration time update circuit updates the first integration time in the next conversion period based on the second integration time in the current conversion period.

3. The semiconductor device according to Claim 1, wherein
   the control circuit controls an input to the integrator so that the integrator integrates an analog signal and a first reference voltage twice within a predetermined conversion period, and

the integration time update circuit updates the second the first integration time within the conversion period based on the first the second integration time within the conversion period.

4. The semiconductor device according to Claim 2, wherein the integration time update circuit updates the first integration time based on a time length of a period obtained by excluding a predetermined margin period from the conversion period.

5. An onboard system comprising:

a detection unit that detects a state of a vehicle;
a semiconductor device according to any of Claims 1 to 4 that calculates a digital value of an analog signal, which is a detection result obtained by the detection unit, and measures a state value of the vehicle; and
a control unit that controls the vehicle based on the state value measured by the semiconductor device.

6. The onboard system according to Claim 5, wherein
the detection unit detects a plurality of detection targets,
an analog signal of a sequentially selected one detection target is input to the semiconductor device, and
the semiconductor device sequentially calculates digital values of the analog signals of the plurality of detection targets.

7. An analog-to-digital conversion method comprising:

integrating a first reference voltage after integrating an analog signal for a first integration time;
counting a second integration time until an integration result reaches a second reference voltage from start of the integration of the first reference voltage;
updating the first integration time based on the counted second integration time;
integrating the first reference voltage after integrating an analog signal for the updated first integration time;
counting the second integration time after integrating an analog signal for the updated first integration time; and
calculating a digital value of the analog signal based on the updated first integration time and the second integration time after integrating the analog signal for the updated first integration time.

8. A measurement method comprising:

detecting a state of a vehicle as an analog signal;
the steps of the conversion method of Claim 7 by integrating a first reference voltage after integrating the detected analog signal for a first integration time;
counting a second integration time until an integration result reaches a second reference voltage from start of integration of the first reference voltage;
updating the first integration time based on the counted second integration time;
integrating the first reference voltage after integrating a newly detected analog signal for the updated first integration time;
counting the second integration time after integrating the newly detected analog signal; and
calculating a digital value of the newly detected analog signal based on the updated first integration time and the second integration time after integrating the analog signal, and measuring a state value of the vehicle.

9. The method according to Claim 7 or 8, further comprising:

integrating an analog signal and a first reference voltage once within a predetermined conversion period; and
updating the first integration time in the next conversion period based on the second integration time in the current conversion period.

10. The method according to Claim7 or 8, further comprising:

integrating an analog signal and a first reference voltage twice within a predetermined conversion period; and
updating the second the first integration time within the conversion period based on the first the second integration time within the conversion period.

11. The method according to Claim 9, further comprising updating the first integration time based on a time length of a period obtained by excluding a predetermined margin period from the conversion period.

Fig. 1

<u>1</u>

Fig. 2

INTEGRATION OUTPUT Vo

FIRST CONVERSION Tconv | Tinterval | SECOND CONVERSION Tconv | Tinterval | THIRD CONVERSION Tconv | Tinterval

Tconv' | Tmargin | Tconv' | Tmargin

t0 t1 t2 t3 t4 t5 t6 t7 t8 t9 t10 t11 TIME

| | | | | | |
|---|---|---|---|---|---|
| SWITCH SWITCHING SIGNAL S1 | | | | | |
| COMPARATOR OUTPUT SIGNAL S2 | | | | | |
| COUNTER VALUE | 0··· T1_1 | 0··· T2_1 | 0 | 0········T1_2 | 0········T2_2 | 0 | 0········T1_3 | 0········T2_3 | 0 | 0····· |
| TIME T1 | T1_1 (INITIAL VALUE) | T1_2 | T1_3 | |
| TIME T2 | 0 | T2_1 | T2_2 | T2_3 |
| TIME COEFFICIENT α_N | − | α_1 | α_2 | α_3 |
| MEASUREMENT RESULT S3 | 0 | MEASUREMENT RESULT OF Van OF FIRST CONVERSION | MEASUREMENT RESULT OF Van OF SECOND CONVERSION | |

19

Fig. 3

Fig. 4A

RELATED ART

Fig. 4B

2

Fig. 5

25

27

26

21

| DETECTION UNIT | | S10 | | SENSOR I/F UNIT | | MCU | | S11 | ENGINE 20 |

3

Fig. 6

Fig. 7

3

Fig. 8                                        4

Fig. 9

Fig. 10

Fig. 11

5

Fig. 12

RELATED ART

Fig. 13

9

RELATED ART

Fig. 14

Fig. 15

Europäisches
Patentamt

European
Patent Office

Office européen
des brevets

# EUROPEAN SEARCH REPORT

Application Number

EP 15 18 1503

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 4 633 221 A (BRADSHAW PETER D [US] ET AL) 30 December 1986 (1986-12-30) <br> * column 2, lines 32-35 * <br> * figures 1,3 * <br> * column 3, lines 49-60 * <br> * column 4, lines 20-26 * <br> * column 4, lines 36-51 * <br> * column 3, lines 66-67 * <br> * column 5, lines 28-68 * <br> ----- | 1-11 | INV. <br> H03M1/52 <br> H03M1/18 <br><br> ADD. <br> B60R16/023 |
| X | US 3 703 001 A (HIBBS EUGENE B JR) 14 November 1972 (1972-11-14) <br> * abstract * <br> * column 2, lines 26-35 * <br> * column 9, lines 30-57 * <br> * figures 3,7,8 * <br> ----- | 1-3,5-10 | |
| X | US 4 644 323 A (CHAMRAN MORTEZA M [US] ET AL) 17 February 1987 (1987-02-17) <br> * column 2, line 59 - column 3, line 3 * <br> * column 3, lines 11-14 * <br> * column 4, line 67 - column 5, line 15 * <br> * figures 1-3 * <br> ----- | 1-3,5-10 | TECHNICAL FIELDS SEARCHED (IPC) <br><br> H03M <br> B60R |
| A | WO 96/33386 A1 (CURTIS INSTR [US]) 24 October 1996 (1996-10-24) <br> * the whole document * <br> ----- | 5,6,8 | |

The present search report has been drawn up for all claims

| Place of search | Date of completion of the search | Examiner |
|---|---|---|
| The Hague | 12 January 2016 | Rocha, Daniel |

EPO FORM 1503 03.82 (P04C01)

## ANNEX TO THE EUROPEAN SEARCH REPORT
## ON EUROPEAN PATENT APPLICATION NO.

EP 15 18 1503

This annex lists the patent family members relating to the patent documents cited in the above-mentioned European search report.
The members are as contained in the European Patent Office EDP file on
The European Patent Office is in no way liable for these particulars which are merely given for the purpose of information.

12-01-2016

| Patent document cited in search report | | Publication date | Patent family member(s) | | Publication date |
|---|---|---|---|---|---|
| US 4633221 | A | 30-12-1986 | NONE | | |
| US 3703001 | A | 14-11-1972 | NONE | | |
| US 4644323 | A | 17-02-1987 | NONE | | |
| WO 9633386 | A1 | 24-10-1996 | CN | 1185829 A | 24-06-1998 |
| | | | EP | 0827585 A1 | 11-03-1998 |
| | | | JP | H11505323 A | 18-05-1999 |
| | | | US | 6202039 B1 | 13-03-2001 |
| | | | WO | 9633386 A1 | 24-10-1996 |

EPO FORM P0459

For more details about this annex : see Official Journal of the European Patent Office, No. 12/82

**EP 2 988 422 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2014169535 A
- JP 5083135 A
- JP 3023719 A